# EUROPEAN PATENT APPLICATION

(11) **EP 4 756 462 A1**
(43) Date of publication of application: **10.06.2026**
(21) Application number: 25745258.1
(22) Date of filing: 24.01.2025
(51) Int. Cl.: G01R 31/396, G01R 31/382, G01R 31/371, G01R 19/12, B60L 58/10

(54) **APPARATUS AND METHOD FOR GENERATING BATTERY INFORMATION**

(30) Priority: 26.01.2024 KR 20240012350
(71) Applicant: LG Energy Solution, Ltd., Seoul 07335 (KR)
(72) Inventor: CHOI, Soon-Hyung, Daejeon 34122 (KR); KIM, Young-Deok, Daejeon 34122 (KR)
(74) Representative: Goddar, Heinz J.
(86) International application number: PCT/KR2025/001528
(87) International publication number: WO 2025/159592

(57) **Abstract**

A battery information generating apparatus according to an embodiment of the present disclosure includes: a profile acquisition unit that acquires a battery profile representing a correspondence between a capacity and a voltage of a battery; and a control unit that sets a positive electrode voltage section corresponding to the battery based on a preset negative electrode flat section, adjusts a preset reference positive electrode profile and a reference negative electrode profile to correspond to the battery profile based on the positive electrode voltage section, and generates a positive electrode profile and a negative electrode profile of the battery based on an adjustment result.

## Description

### TECHNICAL FIELD

This application is based on and claims priority from Korean Patent Application No. 10-2024-0012350, filed on January 26, 2024, with the Korean Intellectual Property Office, the disclosure of which is incorporated herein in its entirety by reference.

The present disclosure relates to a battery information generating apparatus and method, more particularly, an apparatus and method for generating battery information more accurately reflecting the state of a battery.

### BACKGROUND

Recently, with the rapidly increasing demand for portable electronic products such as notebook computers, video cameras, and portable telephones, and the accelerating development of electric vehicles, energy storage batteries, robots, and satellites, researches on the high-performance batteries allowing repeated charging and discharging are actively underway.

Currently, commercially available batteries include, for example, nickel-cadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

### DISCLOSURE

### Technical Problem

The present disclosure provides a battery information generating apparatus and method, which may generate a more accurate profile used to diagnose the state of a battery.

Various aspects of the present disclosure may be understood from the descriptions herein below, and may be more clearly understood from embodiments of the present disclosure. Further, it is readily apparent that various aspects of the present disclosure may be implemented by elements described in the claims and combinations thereof.

### Technical Solution

A battery information generating apparatus according to an aspect of the present disclosure may include: a profile acquisition unit that acquires a battery profile representing a correspondence between a capacity and a voltage of a battery; and a control unit that sets a positive electrode voltage section corresponding to the battery based on a preset negative electrode flat section, adjusts a preset reference positive electrode profile and a reference negative electrode profile to correspond to the battery profile based on the positive electrode voltage section, and generates a positive electrode profile and a negative electrode profile of the battery based on an adjustment result.

The control unit may be configured to set the positive electrode voltage section based on a target voltage section corresponding to the negative electrode flat section and a final voltage of the battery profile.

The control unit may be configured to set a value obtained by summing a lower limit voltage of the target voltage section and the final voltage as a lower limit voltage of the positive electrode voltage section, and set a value obtained by summing an upper limit voltage of the target voltage section and the final voltage as an upper limit voltage of the positive electrode voltage section.

The control unit may be configured to adjust the reference positive electrode profile and the reference negative electrode profile such that the final voltage of the positive electrode profile is included in the positive electrode voltage section.

The negative electrode flat section may be preset to a capacity section in which a change rate of the voltage with respect to the capacity is a preset reference rate or less in the reference negative electrode profile.

The negative electrode flat section may be preset to a capacity section equal to or more than a capacity of a target peak included in a reference differential profile based on the reference positive electrode profile and the reference negative electrode profile.

The target peak may be set to a maximum point with a largest corresponding differential voltage among a plurality of maximum points included in the reference differential profile.

The control unit may be configured to output the positive electrode profile and the negative electrode profile to an outside, to provide information about the battery.

A battery pack according to another aspect of the present disclosure may include the battery information generating apparatus according to an aspect of the present disclosure.

A vehicle according to yet another aspect of the present disclosure may include the battery information generating apparatus according to an aspect of the present disclosure.

A battery information generating method according to still yet another aspect of the present disclosure may include: a profile acquisition step of acquiring a battery profile representing a correspondence between a capacity and a voltage of a battery; a positive electrode voltage section setting step of setting a positive electrode voltage section corresponding to the battery based on a preset negative electrode flat section; a profile adjustment step of adjusting a preset reference positive electrode profile and reference negative electrode profile to correspond to the battery profile based on the positive electrode voltage section; and a profile generation step of generating a positive electrode profile and a negative electrode profile of the battery based on an adjustment result in the profile adjustment step.

The positive electrode voltage section setting step may include setting the positive electrode voltage section based on a target voltage section corresponding to the negative electrode flat section and a final voltage of the battery profile.

The positive electrode voltage section setting step may include setting a value obtained by summing a lower limit voltage of the target voltage section and the final voltage as a lower limit voltage of the positive electrode voltage section, and setting a value obtained by summing an upper limit voltage of the target voltage section and the final voltage as an upper limit voltage of the positive electrode voltage section.

The profile adjustment step may include adjusting the reference positive electrode profile and the reference negative electrode profile such that the final voltage of the positive electrode profile is included in the positive electrode voltage section.

The negative electrode flat section may be preset to a capacity section in which a change rate of the voltage with respect to the capacity is a preset reference rate or less in the reference negative electrode profile.

The negative electrode flat section may be preset to a capacity section equal to or more than a capacity of a target peak included in a reference differential profile based on the reference positive electrode profile and the reference negative electrode profile.

The target peak may be set to a maximum point with a largest corresponding differential voltage among a plurality of maximum points included in the reference differential profile.

The battery information generation method may further include: outputting the positive electrode profile and the negative electrode profile to an outside, to provide information about the battery.

A non-transitory computer-readable storage medium according to still yet another aspect of the present disclosure may store therein a program for performing a battery information generating method including: a profile acquisition step of acquiring a battery profile representing a correspondence between a capacity and a voltage of a battery; a positive electrode voltage section setting step of setting a positive electrode voltage section corresponding to the battery based on a preset negative electrode flat section; a profile adjustment step of adjusting a preset reference positive electrode profile and reference negative electrode profile to correspond to the battery profile based on the positive electrode voltage section; and a profile generation step of generating a positive electrode profile and a negative electrode profile of the battery based on an adjustment result in the profile adjustment step.

### Advantageous Effects

According to an aspect of the present disclosure, the battery information generating apparatus may adjust the reference positive electrode profile and the reference negative electrode profile by adding the condition requiring that the final voltage of the positive electrode profile be included in the positive electrode voltage section, so that it is possible to dramatically reduce the time for generating the positive electrode profile and the negative electrode profile corresponding to the battery.

The effects of the present disclosure are not limited to those described above, and other effects that are not described herein may clearly be understood to those skilled in the art from the descriptions in the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery information generating apparatus according to an embodiment of the present disclosure.
FIG. 2 is a view schematically illustrating a battery profile according to an embodiment of the present disclosure.
FIG. 3 is a view schematically illustrating a reference positive electrode profile and a reference negative electrode profile according to an embodiment of the present disclosure.
FIG. 4 is a view schematically illustrating an adjustment result according to an embodiment of the present disclosure.
FIG. 5 is a view schematically illustrating a reference differential profile according to an embodiment of the present disclosure.
FIG. 6 is a view schematically illustrating a battery pack according to another embodiment of the present disclosure.
FIG. 7 is a view schematically illustrating a vehicle according to yet another embodiment of the present disclosure.

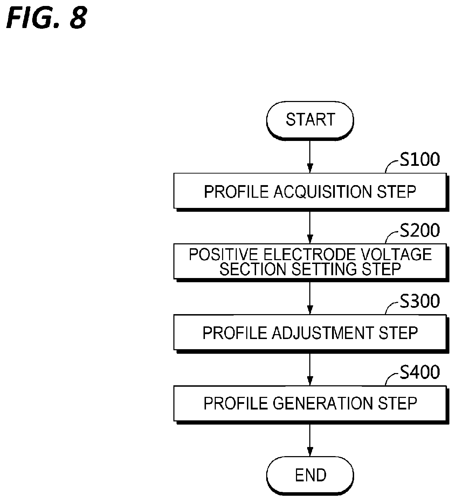

FIG. 8 is a view schematically illustrating a battery information generating method according to still yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from the other, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

Hereinafter, embodiments of the present disclosure will be described in detail with reference to the accompanying drawings.

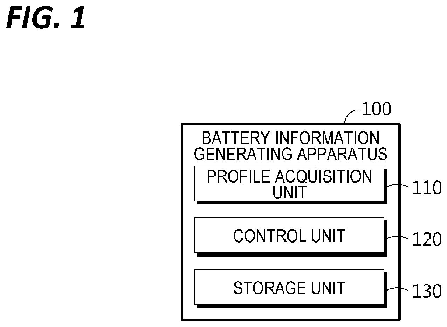

FIG. 1 is a view schematically illustrating a battery information generating apparatus 100 according to an embodiment of the present disclosure.

Referring to FIG. 1, the battery information generating apparatus 100 may include a profile acquisition unit 110 and a control unit 120.

Here, a battery subjected to information generation indicates a single isolated cell that is physically separable and has a negative electrode terminal and a positive electrode terminal. For example, a lithium-ion battery or a lithium polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Herein below, for the convenience of description, it is assumed that the battery indicates a single isolated cell.

The profile acquisition unit 110 may be configured to acquire a battery profile BP representing a correspondence between the capacity and the voltage of a battery.

For example, the battery profile BP is a profile representing a correspondence between the voltage (V) and the capacity (Q) of a battery when the battery is charged from a preset charging start SOC or 0 % to a preset charging termination SOC or 100 %. In another example, the battery profile BP may represent a correspondence between the voltage (V) and the capacity (Q) of a battery when the battery is discharged from a preset discharging start SOC or 100 % to a preset discharging termination SOC or 0 %.

For example, the C-rate of the charging or discharging for generating the battery profile BP is not particularly limited. However, in order to acquire a more accurate battery profile, the battery needs to be charged or discharged at a low rate. For example, the battery profile BP may be generated during the process of charging or discharging the battery at 0.05 C.

For example, the profile acquisition unit 110 may directly read or receive the battery profile BP of the battery from the outside. For example, the profile acquisition unit 110 may acquire the battery profile BP by being connected to the outside via a wired and/or wireless network to read or receive the battery profile BP.

In another example, the profile acquisition unit 110 may generate the battery profile BP based on battery information about the voltage and the capacity of the battery. For example, the profile acquisition unit 110 may acquire the battery profile BP by directly generating the battery profile BP based on the battery information.

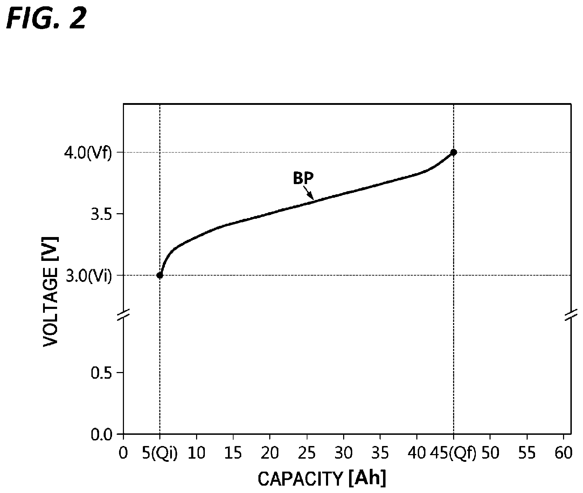

FIG. 2 is a view schematically illustrating the battery profile BP according to an embodiment of the present disclosure. The battery profile BP may be represented as an X-Y graph in which the X axis is set as the capacity (Q), and the Y axis is set as the voltage (V).

For example, the initial voltage of the battery profile BP (*e.g.,* the charging start voltage of the battery) is Vi [V], and the final voltage thereof (*e.g.,* the charging termination voltage) is Vf [V]. The initial capacity of the battery profile BP (*e.g.,* the charging start capacity of the battery) is Qi [Ah], and the final capacity thereof (*e.g.,* the charging termination capacity) is Qf [Ah].

In the embodiment of FIG. 2, the initial voltage Vi of the battery profile BP is 3.0 [V], and the final voltage Vf thereof is 4.0 [V]. The initial capacity Qi of the battery profile BP is 5 [Ah], and the final capacity Qf thereof is 45 [Ah].

The profile acquisition unit 110 may be connected to the control unit 120 for a communication. For example, the profile acquisition unit 110 may be connected to the control unit 120 in the wired or wireless manner. Through this connection, the profile acquisition unit 110 may transmit the acquired battery profile BP to the control unit 120. In another example, the control unit 120 may read the battery profile BP from the profile acquisition unit 120 at a required time point.

The control unit 120 may be configured to set a positive electrode voltage section PR corresponding to the battery based on a preset negative electrode flat section RR.

Here, the negative electrode flat section RR is a capacity section where the voltage change of the negative electrode with the increase in capacity of the negative electrode is insignificant, and may be preset. For example, a capacity section where the voltage change with respect to the capacity is a certain level or less may be preset as the negative electrode flat section RR. An embodiment of the negative electrode flat section RR will be described herein later.

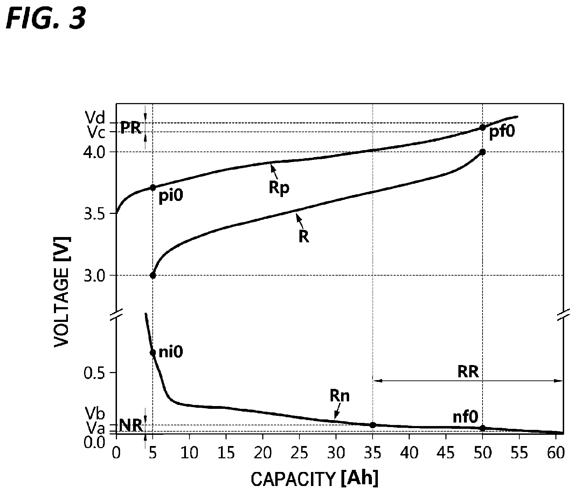

FIG. 3 is a view schematically illustrating a reference positive electrode profile Rp and a reference negative electrode profile Rn according to an embodiment of the present disclosure. For example, in the embodiment of FIG. 3, the capacity section where the change of the negative electrode voltage with respect to the capacity is the certain level or less in the reference negative electrode profile Rn (35 [Ah] to about 60 [Ah]) may be preset as the negative electrode flat section RR.

First, the control unit 120 may be configured to set the positive electrode voltage section PR based on a negative electrode voltage section NR corresponding to the negative electrode flat section RR, and the final voltage of the battery profile BP.

A lower limit capacity and an upper limit capacity of the negative electrode flat section RR may be set for the preset reference negative electrode profile Rn. Then, the negative electrode voltage section NR may be set to a voltage section including the voltage corresponding to the upper limit capacity of the negative electrode flat section RR and the voltage corresponding to the lower limit capacity thereof.

For example, in the embodiment of FIG. 3, the lower limit capacity of the negative electrode flat section RR is 35 [Ah], and the upper limit capacity thereof is about 60 [Ah]. The voltage corresponding to the lower limit capacity is Vb [V], and the voltage corresponding to the upper limit capacity is Va [V]. Thus, the negative electrode voltage section NR may be set to a voltage section of Va to Vb.

The difference between the positive electrode voltage and the negative electrode voltage at the same capacity represents the voltage of the battery. In other words, the sum of the voltage of the battery and the negative electrode voltage at the same capacity represents the positive electrode voltage. Thus, the control unit 120 may set the positive voltage section PR according to the voltage included in the negative electrode voltage section NR and the voltage of the battery, taking into account the correlation among the voltage of the battery, the positive electrode voltage, and the negative electrode voltage.

In general, the capacity at which the reaction of the negative electrode terminates during the charging process of the battery is included in the negative electrode flat section RR. Further, the capacity at which the reaction of the negative electrode starts during the discharging process of the battery is included in the negative electrode flat section RR. For example, the negative electrode voltage corresponding to the final voltage Vf of the battery profile BP is included in the negative electrode voltage section NR. Here, since the positive electrode voltage is a value obtained by summing the voltage of the battery and the negative electrode voltage, the positive electrode voltage corresponding to the final voltage Vf of the battery profile BP may be included in the positive electrode voltage section PR, which is the sum of the final voltage Vf of the battery profile BP and the negative electrode voltage section NR. Thus, the control unit 120 may set the positive electrode voltage section PR by summing the negative electrode voltage section NR corresponding to the negative electrode flat section RR and the final voltage Vf of the battery profile BP.

For example, the control unit 120 may be configured to set a value obtained by summing the lower limit voltage of the negative electrode voltage section NR and the final voltage of the battery profile BP as the lower limit voltage of the positive electrode voltage section PR. Then, the control unit 120 may be configured to set a value obtained by summing the upper limit voltage of the negative electrode voltage section NR and the final voltage of the battery profile BP as the upper limit voltage of the positive electrode voltage section PR.

In the embodiments of FIGS. 2 and 3, the final voltage of the battery profile BP is Vf [V], the lower limit voltage of the negative electrode voltage section NR is Va [V], and the upper limit voltage of the negative electrode voltage section NR is Vb [V]. The control unit 120 may set a value obtained by summing the final voltage Vf of the battery profile BP and the lower limit voltage Va of the negative electrode voltage section NR as the lower limit voltage Vc of the positive electrode voltage section PR. Then, the control unit 120 may set a value obtained by summing the final voltage Vf of the battery profile BP and the upper limit voltage Vb of the negative electrode voltage section NR as the upper limit voltage Vd of the positive electrode voltage section PR. For example, the lower limit voltage Vc of the positive electrode voltage section PR may be set according to the arithmetic formula "Vc=Vf+Va," and the upper limit voltage Vd of the positive electrode voltage range PR may be set according to the arithmetic formula "Vd=Vf+Vb."

The control unit 120 may be configured to adjust a preset reference positive electrode profile Rp and a preset reference negative electrode profile Rn to correspond to the battery profile BP based on the positive electrode voltage section PR, and generate the positive electrode profile and the negative electrode profile of the battery according to the adjustment result.

Here, the reference positive electrode profile Rp may be a profile representing a correspondence between the capacity and the voltage of a reference positive electrode cell preset to correspond to the positive electrode of the battery. For example, the reference positive electrode cell may be a positive electrode coin half cell or the positive electrode of a three-electrode cell. The reference negative electrode profile Rn may be a profile representing a correspondence between the capacity and the voltage of a reference negative electrode cell preset to correspond to the negative electrode of the battery. For example, the reference negative electrode cell may be a negative electrode coin half cell or the negative electrode of a three-electrode cell.

For example, in the embodiment of FIG. 3, the reference positive electrode profile Rp may include a positive electrode activation initial point pi0 and a positive electrode activation final point pf0, and the reference negative electrode profile Rn may include a negative electrode activation initial point ni0 and a negative electrode activation final point nf0. The initial voltage of the reference profile R corresponds to the voltage difference between the positive electrode activation initial point pi0 and the negative electrode activation initial point ni0, and the final voltage of the reference profile R corresponds to the voltage difference between the positive electrode activation final point pf0 and the negative electrode activation final point nf0. Here, the capacity of the negative electrode activation final point nf0 may be included in the negative electrode flat section RR. The voltage of the positive electrode activation final point pf0 may be included in the positive electrode voltage section PR.

The control unit 120 may adjust the reference positive electrode profile Rp and the reference negative electrode profile Rn to correspond to the battery profile BP. For example, the control unit 120 may adjust the reference positive electrode profile Rp and the reference negative electrode profile Rn, to generate an adjusted positive electrode profile Rp' and an adjusted negative electrode profile Rn'. Then, the control unit 120 may generate a comparative profile R' from the adjusted positive electrode profile Rp' and the adjusted negative electrode profile Rn'. The control unit 120 may repeatedly adjust the reference positive electrode profile Rp and the reference negative electrode profile Rn until the comparative profile R' corresponds to the battery profile BP.

For example, the control unit 120 may shift the reference positive electrode profile Rp and the reference negative electrode profile Rn or perform a capacity scaling to generate a plurality of comparative profiles R', and identify a comparative profile R' having a minimum error (*e.g*., root mean squared error (RMSE)) with the battery profile BP, among the plurality of comparative profiles R'. Then, the control unit 120 may set the adjusted positive electrode profile Rp' corresponding to the identified comparative profile R' as the positive electrode profile of the battery. Then, the control unit 120 may set the adjusted negative electrode profile Rn' corresponding to the identified comparative profile R' as the negative electrode profile of the battery. For example, the adjusted positive electrode profile Rp' and the adjusted negative electrode profile Rn' corresponding to the identified comparative profile R' may be estimated as the positive electrode profile and the negative electrode profile of the battery, respectively.

According to an embodiment, the control unit 120 may be configured to adjust the reference positive electrode profile Rp and the reference negative electrode profile Rn such that the final voltage of the positive electrode profile is included in the positive electrode voltage section PR. For example, the control unit 120 may adjust the reference positive electrode profile Rp and the reference negative electrode profile Rn such that the voltage of the positive electrode activation final point of the adjusted positive electrode profile Rp' is included in the positive electrode voltage section PR.

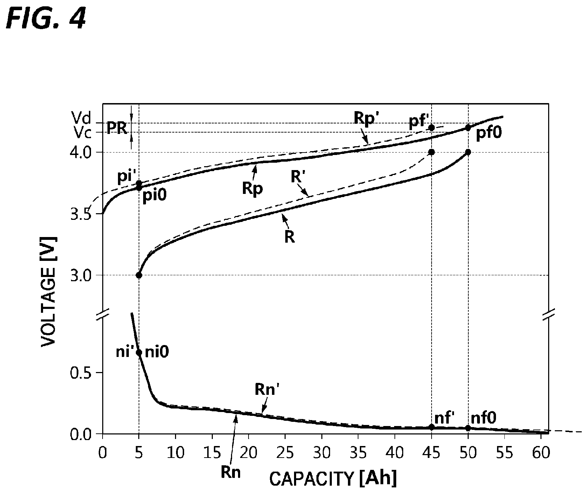

FIG. 4 is a view schematically illustrating the adjustment result according to an embodiment of the present disclosure.

For example, in the embodiment of FIG. 4, the reference positive electrode profile Rp may be adjusted to generate the adjusted positive electrode profile Rp', and the reference negative electrode profile Rn may be adjusted to generate the adjusted negative electrode profile Rn'. The adjusted positive electrode profile Rp' includes the positive electrode activation initial point pi' and the positive electrode activation final point pf', and the adjusted negative electrode profile Rn' includes the negative electrode activation initial point ni' and the negative electrode activation final point nf. The initial voltage of the comparative profile R' corresponds to the voltage difference between the positive electrode activation initial point pi' and the negative electrode activation initial point ni', and the final voltage of the comparative profile R' corresponds to the voltage difference between the positive electrode activation final point pf and the negative electrode activation final point nf. Here, the voltage of the positive electrode activation final point pf of the adjusted positive electrode profile Rp' may be included in the positive electrode voltage section PR.

The battery information generating apparatus 100 according to an embodiment of the present disclosure may adjust the reference positive electrode profile Rp and the reference negative electrode profile Rn by adding a condition requiring that the final voltage of the positive electrode profile be included in the positive electrode voltage section PR.

According to an embodiment of the present disclosure, since the battery information generating apparatus 100 does not consider a case where the final voltage of the positive electrode profile deviates from the positive electrode voltage section PR during the process of adjusting the reference positive electrode profile Rp and the reference negative electrode profile Rn, it may dramatically reduce the time for generating the positive electrode profile and the negative electrode profile, as compared to a case where the final voltage of the positive electrode profile is not limited. This is because the number of the plurality of comparative profiles R' compared to the battery profile BP is reduced due to the condition requiring that the final voltage of the positive electrode profile be included in the positive electrode voltage section PR.

Referring to FIGS. 2 and 4, even though the negative electrode voltage section NR and the positive electrode voltage section PR have the same size, the corresponding capacity sections thereof are significantly different. This is because the change in negative electrode voltage with respect to the capacity is very small, as compared to the change in positive electrode voltage with respect to the capacity. For example, the condition for adjusting the reference positive electrode profile Rp and the reference negative electrode profile Rn may be further limited by limiting the final voltage of the positive electrode profile within the positive electrode voltage section PR, rather than limiting the final voltage of the negative electrode profile within the negative electrode voltage section NR.

For example, in the embodiment of FIG. 4, when the voltage of the negative electrode activation final point nf of the negative electrode profile Rn' is limited to fall within the negative electrode voltage section NR, the voltage of the positive electrode activation final point pf of the positive electrode profile Rp' may be included in the positive electrode voltage section PR. However, since the capacity difference between the negative electrode activation initial point ni' and the negative electrode activation final point nf of the negative electrode profile Rn' is required to correspond to the capacity (Qf-Qi) of the battery, the negative electrode activation initial point ni' may be present on the excessively high voltage (or low capacity) side, or the scale of the reference negative electrode profile Rn may excessively change (*e.g*., increase). Further, since the voltage difference between the positive electrode activation initial point pi' and the negative electrode activation initial point ni' is required to correspond to the initial voltage Vi of the battery profile, the positive electrode activation initial point pi' may be present on the high voltage (or high capacity) side, or the scale of the reference positive electrode profile Rp may excessively change (*e.g.,* increase). For example, the change rate of the negative electrode voltage with respect to the capacity is very small in the negative electrode flat section RR, and therefore, when the voltage of the negative electrode activation final point nf of the negative electrode profile Rn' is limited to fall within the negative electrode voltage section NR, it is not easy to acquire the comparative profile R'. Thus, the battery information generating apparatus 100 sets the adjustment condition for the positive electrode profile, instead of the negative electrode profile, and therefore, may more quickly and accurately generate the positive electrode profile and the negative electrode profile of the battery.

Meanwhile, the profile acquisition unit 110 and/or the control unit 120 provided in the battery information generating apparatus 100 may selectively include, for example, a processor, an application-specific integrated circuit (ASIC), other chipsets, logic circuits, registers, a communication modem, and a data processing apparatus, which are well-known in the art, in order to execute various control logics performed in the present disclosure. When the control logics are implemented by software, the profile acquisition unit 110 and/or the control unit 120 may be implemented as a set of program modules. In this case, the program modules may be stored in a memory, and executed by the profile acquisition unit 110 and/or the control unit 120. The memory may be provided inside or outside the profile acquisition unit 110 and/or the control unit 120, and may be connected to the profile acquisition unit 110 and/or the control unit 120 by various well-known means.

The battery information generating apparatus 100 may further include the storage unit 130. The storage unit 130 may store, for example, data or programs necessary when each component of the battery information generating apparatus 100 performs the operation and function thereof, or data generated when the operation and function are performed. The storage unit 130 is not particularly limited in type as long as it is a well-known information storage means capable of recording, erasing, updating, and reading data. In an example, the information storage means may include, for example, a random access memory (RAM), a flash memory, a read-only memory (ROM), an electronically erasable programmable read-only memory (EEPROM), and a register. Further, the storage unit 130 may store program codes, in which processes executable by the profile acquisition unit 110 and/or the control unit 120 are defined.

For example, in the storage unit 130, information representing the voltage of each of the reference positive electrode activation initial point pi0, the reference positive electrode activation final point pf0, the reference negative electrode activation initial point ni0, and the reference negative electrode activation final point nf0 may be recorded in advance. The voltage difference between the reference positive electrode activation initial point pi0 and the reference negative electrode activation initial point ni0 may be equal to a first set voltage (*e.g.,* 3.0 [V]). The voltage difference between the reference positive electrode activation final point pf0 and the reference negative electrode activation final point nf0 may be equal to a second set voltage (*e.g.,* 4.0 [V]).

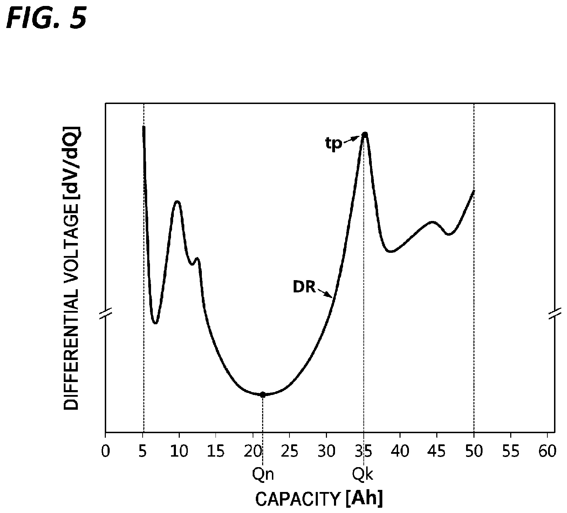

Hereinafter, the negative electrode flat section RR will be described with reference to FIGS. 3 and 5.

It is generally obvious that in the capacity section subsequent to a target peak tp, the positive electrode reacts dominantly, and the negative electrode participates less in the reaction. Due to the difference in degree of reaction participation between the positive electrode and the negative electrode, the change rate of the voltage with respect to the capacity is not significant in the negative electrode flat section RR.

In an embodiment, the negative electrode flat section RR may be preset to a capacity section where the change rate of the voltage with respect to the capacity is a preset reference rate or less in the reference negative electrode profile Rn.

In the embodiment of FIG. 3, the change rate of the voltage may be the reference rate or less in the capacity section of 35 [Ah] to about 60 [Ah]. Thus, the capacity section of 35 [Ah] to about 60 [Ah] may be set as the negative electrode flat section RR.

In another embodiment, the negative electrode flat section RR may be preset to a capacity section equal to or more than the capacity of the target peak tp included in the reference differential profile DR based on the reference positive electrode profile Rp and the reference negative electrode profile Rn. Here, the target peak tp may be set to a maximum point with the largest corresponding differential voltage among a plurality of maximum points included in the reference differential profile DR.

FIG. 5 is a view schematically illustrating the reference differential profile DR according to an embodiment of the present disclosure. The reference differential profile DR is a profile representing a correspondence between the capacity (Q) and the differential voltage (dV/dQ). Here, the differential voltage (dV/dQ) is a value obtained by differentiating the voltage (V) with respect to the capacity (Q), and refers to the instantaneous change rate of the voltage with respect to the capacity.

The reference differential profile DR according to the embodiment of FIG. 5 is a profile derived by differentiating the reference profile R according to the embodiment of FIG. 3 with respect to the capacity. The reference differential profile DR may include a plurality of minimum points and a plurality of maximum points.

For example, among the plurality of maximum points, a maximum point with the largest corresponding differential voltage may be set as the target peak tp. In the embodiment of FIG. 5, among the plurality of maximum points, the maximum point corresponding to the capacity Qk [Ah] may be determined to be the target peak tp.

In another example, in a capacity section equal to or more than the capacity of a minimum point with the smallest corresponding differential voltage among the plurality of minimum points, a maximum point with the largest corresponding differential voltage may be set as the target peak tp. In the embodiment of FIG. 5, among the plurality of minimum points, the differential voltage of the minimum point corresponding to the capacity Qn [Ah] is the smallest. Thus, the target peak tp may be determined from the plurality of maximum points included in the capacity section equal to or more than Qn [Ah].

Hereinafter, descriptions will be made on an embodiment where the control unit 120 adjusts the reference positive electrode profile Rp and the reference negative electrode profile Rn.

Referring to FIG. 4, the control unit 120 may contract or expand the reference positive electrode profile Rp such that the size of the capacity range between the two points pi0 and pf0 of the reference positive electrode profile Rp matches the size of the capacity range of the battery profile BP, to generate the adjusted positive electrode profile Rp'. As a result, the capacity difference between the two points pi' and pf of the adjusted positive electrode profile Rp' may match the capacity range of the battery profile BP.

Further, the control unit 120 may contract or expand the reference negative electrode profile Rn such that the size of the capacity range between the two points ni and nf of the reference negative electrode profile Rn also matches the size of the capacity range of the battery profile BP, to generate the adjusted negative electrode profile Rn'. As a result, the capacity difference between the two points ni' and nf of the adjusted negative electrode profile Rn' may match the capacity range of the battery profile BP.

In FIG. 4, the adjusted positive electrode profile Rp' is the result of contracting the reference positive electrode profile Rp, and the adjusted negative electrode profile Rn' is the result of expanding the reference negative electrode profile Rn.

The positive electrode activation final point pf on the adjusted positive electrode profile Rp' corresponds to the positive electrode activation final point pf on the reference positive electrode profile Rp. The negative electrode activation final point nf on the adjusted negative electrode profile Rn' corresponds to the negative electrode activation final point nf on the reference negative electrode profile Rn.

The capacity difference between the positive electrode activation initial point pi' and the positive electrode activation final point pf of the adjusted positive electrode profile Rp' matches the size of the capacity range of the battery profile BP. Similarly, the capacity difference between the negative electrode activation initial point ni' and the negative electrode activation final point nf of the adjusted negative electrode profile Rn' matches the size of the capacity range of the battery profile BP.

Further, the capacity range by the two points pi' and pf of the adjusted positive electrode profile Rp' matches the capacity range by the two points ni' and nf of the adjusted negative electrode profile Rn'. The control unit 120 may subtract the profile between the two points pi' and pf of the adjusted positive electrode profile Rp' from the profile between the two points ni' and nf of the adjusted negative electrode profile Rn', to generate the comparative profile R'.

The control unit 120 may compute an error between the battery profile BP and the comparative profile R' (profile error).

The control unit 120 may adjust the reference positive electrode profile Rp and the reference negative electrode profile Rn to generate the plurality of comparative profiles R', and compute an error between each of the plurality of comparative profiles R' and the battery profile BP. Then, the control unit 120 may identify a comparative profile R' with the smallest computed error among the plurality of comparative profiles R'. Lastly, the control unit 120 may set the adjusted positive electrode profile Rp' corresponding to the identified comparative profile R' as the positive electrode profile of the battery, and the adjusted negative electrode profile Rn' corresponding to the identified comparative profile R' as the negative electrode profile of the battery.

Then, the control unit 120 may mutually map at least two of the adjusted positive electrode profile Rp', the adjusted negative electrode profile Rn', the positive electrode activation initial point pi', the positive electrode activation final point pf', the negative electrode activation initial point ni', the negative electrode activation final point nf', a first scale factor, a second scale factor, the comparative profile R', and the profile error, and record the mapped information in the storage unit 130.

The first scale factor may represent the ratio of the capacity difference between the two points pi' and pf to the capacity difference between the two points pi0 and pf0. The second scale factor may represent the ratio of the capacity difference between the two points ni' and nf to the capacity difference between the two points ni0 and nf0. For example, the first scale factor is a modification rate of the adjusted positive electrode profile Rp' with respect to the reference positive electrode profile Rp, which refers to a positive electrode modification rate. The second scale factor is a modification rate of the adjusted negative electrode profile Rn' with respect to the reference negative electrode profile Rn, which refers to a negative electrode modification rate.

The control unit 120 may be configured to output the positive electrode profile and the negative electrode profile to the outside, to provide information about the battery.

According to an embodiment, the control unit 120 may be connected to an external device capable of diagnosing the state of the battery, for a communication via a wired or wireless network. The control unit 120 may transmit the positive electrode profile and/or the negative electrode profile to the external device through a wired and/or wireless communication. For example, the external device is not particularly limited as long as it is a device including a diagnosing device or server and capable of analyzing the positive electrode profile and/or the negative electrode profile to diagnose the state of the battery.

Since the positive electrode profile and the negative electrode profile are profiles estimated to represent the current state of the battery, the state of the battery may be diagnosed based on the positive electrode profile and the negative electrode profile.

As described above, the battery information generating apparatus 100 may generate the positive electrode profile and the negative electrode profile used to diagnose the state of the battery, thereby improving the accuracy of the diagnosis of the battery state.

The battery information generating apparatus 100 according to the present disclosure may be applied to a battery management system (BMS). For example, a BMS according to the present disclosure may include the battery information generating apparatus 100 described above. In this configuration, at least a portion of the respective components of the battery information generating apparatus 100 may be implemented by complementing or adding functions of components included in well-known BMSs. For example, the profile acquisition unit 110, the control unit 120, and the storage unit 130 of the battery information generating apparatus 100 may be implemented as components of the BMS.

Further, the battery information generating apparatus 100 according to the present disclosure may be provided in a battery pack. For example, the battery pack according to the present disclosure may include the battery information generating apparatus 100 described above and one or more battery cells. Further, the battery pack may include, for example, electrical components (*e.g*., relays and fuses) and a case.

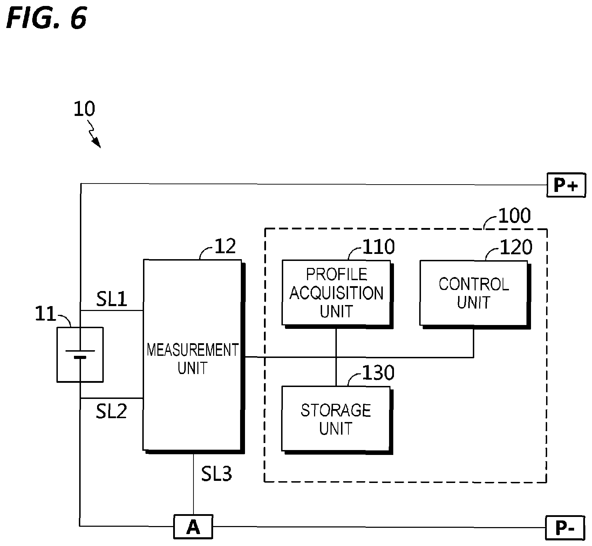

FIG. 6 is a view schematically illustrating an example of the configuration of a battery pack 10 including the battery information generating apparatus 100 according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measurement unit 12 may be connected to a first sensing line SL1, a second sensing line SL2, and a third sensing line SL3. For example, the measurement unit 12 may be connected to the positive electrode terminal of the battery 11 via the first sensing line SL1, and may be connected to the negative electrode terminal of the battery 11 via the second sensing line SL2. The measurement unit 12 may measure the voltage of the battery 11 based on the voltage measured in each of the first sensing line SL1 and the second sensing line SL2.

The measurement unit 12 may be connected to a current measuring unit A via the third sensing line SL3. For example, the current measuring unit A may be an ammeter or a shunt resistor capable of measuring a charging current and a discharging current of the battery 11. The measurement unit 12 may measure the charging current of the battery 11 through the third sensing line SL3 to calculate a charging amount. Further, the measurement unit 12 may measure the discharging current of the battery 11 through the third sensing line SL3 to calculate a discharging amount.

For example, the profile acquisition unit 110 may read or receive the battery information about the voltage and the current of the battery from the measurement unit 12. Then, the profile acquisition unit 110 may generate the battery profile BP based on the battery information.

In another example, the profile acquisition unit 110 may read or receive the battery profile BP from the measurement unit 12.

An external device may be connected to the positive electrode terminal P+ and the negative electrode terminal P- of the battery pack 10. For example, the external device may be a charging device or a load. The positive electrode terminal of the battery 11, the positive electrode terminal P+ of the battery pack 10, the external device, the negative electrode terminal P- of the battery pack 10, and the negative electrode terminal of the battery 11 may be electrically connected to each other.

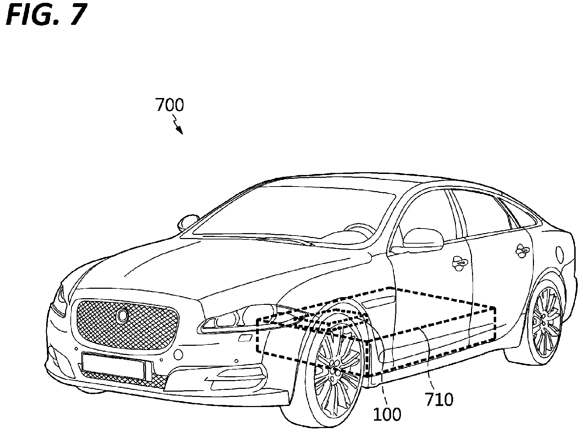

FIG. 7 is a view schematically illustrating a vehicle 700 according to another embodiment of the present disclosure.

Referring to FIG. 7, a battery pack 710 according to an embodiment of the present disclosure may be included in the vehicle 700 such as an electric vehicle (EV) or a hybrid vehicle (HV). The battery pack 710 may supply a power to a motor via an inverter provided in the vehicle 700, to drive the vehicle 700. Here, the battery pack 710 may include the battery information generating apparatus 100. For example, the vehicle 700 may include the battery information generating apparatus 100. In this case, the battery information generating apparatus 100 may be an on-board apparatus included in the vehicle 700.

FIG. 10 is a view schematically illustrating a battery information generating method according to yet another embodiment of the present disclosure.

Referring to FIG. 10, the battery information generating method may include a profile acquisition step S100, a positive electrode voltage section setting step S200, a profile adjustment step S300, and a profile generation step S400.

Each step of the battery information generating method may be performed by the battery information generating apparatus 100. Hereinafter, for the convenience of description, descriptions overlapping with the foregoing descriptions may be omitted or summarized.

The profile acquisition step S100 is a step of acquiring the battery profile BP representing the correspondence between the capacity and the voltage of the battery, and may be performed by the profile acquisition unit 110.

For example, the profile acquisition unit 110 may directly read or receive the battery profile BP from the outside. For example, the profile acquisition unit 110 may acquire the battery profile BP by being connected to the outside via a wired and/or wireless network to read or receive the battery profile BP.

In another example, the profile acquisition unit 110 may generate the battery profile BP based on the battery information about the voltage and the capacity of the battery. For example, the profile acquisition unit 110 may acquire the battery profile BP by directly generating the battery profile BP based on the battery information.

The positive electrode voltage section setting step S200 is a step of setting the positive electrode voltage section PR corresponding to the battery based on the preset negative electrode flat section RR, and may be performed by the control unit 120.

The control unit 120 may be configured to set the positive electrode voltage section PR based on the negative electrode voltage section NR corresponding to the negative electrode flat section RR and the final voltage of the battery profile BP.

For example, the control unit 120 may be configured to set a value obtained by summing the lower limit voltage of the negative electrode voltage section NR and the final voltage of the battery profile BP as the lower limit voltage of the positive electrode voltage section PR. Then, the control unit 120 may be configured to set a value obtained by summing the upper limit voltage of the negative electrode voltage section NR and the final voltage of the battery profile BP as the upper limit voltage of the positive electrode voltage section PR.

The profile adjustment step S300 is a step of adjusting the preset reference positive electrode profile Rp and reference negative electrode profile Rn to correspond to the battery profile BP based on the positive electrode voltage section PR, and may be performed by the control unit 120.

The control unit 120 may adjust the reference positive electrode profile Rp and the reference negative electrode profile Rn such that the voltage of the positive electrode activation final point of the adjusted positive electrode profile Rp' is included in the positive electrode voltage section PR.

The profile generation step S400 is a step of generating the positive electrode profile and the negative electrode profile of the battery according to the adjustment result in the profile adjustment step, and may be performed by the control unit 120.

For example, the control unit 120 may shift the reference positive electrode profile Rp and the reference negative electrode profile Rn or perform a capacity scaling to generate the plurality of comparative profiles R', and identify a comparative profile R' having the smallest error with the battery profile BP among the plurality of comparative profiles R'. Then, the control unit 120 may set the adjusted positive electrode profile Rp' corresponding to the identified comparative profile R' as the positive electrode profile of the battery. Further, the control unit 120 may set the adjusted negative electrode profile Rn' corresponding to the identified comparative profile R' as the negative electrode profile of the battery. For example, the adjusted positive electrode profile Rp' and the adjusted negative electrode profile Rn' corresponding to the identified comparative profile R' may be estimated as the positive electrode profile and the negative electrode profile of the battery, respectively.

The embodiments of the present disclosure described above are not only implemented by an apparatus and method, but may also be implemented by programs implementing functions corresponding to the components of the embodiments of the present disclosure or a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to implement various modifications.

### (Description of Symbols)

10: battery pack
11: battery
12: measurement unit
100: battery information generating apparatus
110: profile acquisition unit
120: control unit
130: storage unit
700: vehicle
710: battery pack

## Claims

1. A battery information generating apparatus comprising:
a profile acquisition unit configured to acquire a battery profile representing a correspondence between a capacity and a voltage of a battery; and
a control unit configured to set a positive electrode voltage section corresponding to the battery based on a preset negative electrode flat section, adjust a preset reference positive electrode profile and a reference negative electrode profile to correspond to the battery profile based on the positive electrode voltage section, and generate a positive electrode profile and a negative electrode profile of the battery based on an adjustment result.

2. The battery information generating apparatus according to claim 1, wherein the control unit is configured to set the positive electrode voltage section based on a target voltage section corresponding to the negative electrode flat section and a final voltage of the battery profile.

3. The battery information generating apparatus according to claim 2, wherein the control unit is configured to set a value obtained by summing a lower limit voltage of the target voltage section and the final voltage as a lower limit voltage of the positive electrode voltage section, and set a value obtained by summing an upper limit voltage of the target voltage section and the final voltage as an upper limit voltage of the positive electrode voltage section.

4. The battery information generating apparatus according to claim 1, wherein the control unit is configured to adjust the reference positive electrode profile and the reference negative electrode profile such that a final voltage of the positive electrode profile is included in the positive electrode voltage section.

5. The battery information generating apparatus according to claim 1, wherein the negative electrode flat section is preset to a capacity section in which a change rate of the voltage with respect to the capacity is a preset reference rate or less in the reference negative electrode profile.

6. The battery information generating apparatus according to claim 1, wherein the negative electrode flat section is preset to a capacity section equal to or more than a capacity of a target peak included in a reference differential profile based on the reference positive electrode profile and the reference negative electrode profile.

7. The battery information generating apparatus according to claim 6, wherein the target peak is set to a maximum point with a largest corresponding differential voltage among a plurality of maximum points included in the reference differential profile.

8. The battery information generating apparatus according to claim 1, wherein the control unit is configured to output the positive electrode profile and the negative electrode profile to an outside, to provide information about the battery.

9. A battery pack comprising the battery information generating apparatus according to any one of claims 1 to 8.

10. A vehicle comprising the battery information generating apparatus according to any one of claims 1 to 8.

11. A battery information generating method comprising:
a profile acquisition step of acquiring a battery profile representing a correspondence between a capacity and a voltage of a battery;
a positive electrode voltage section setting step of setting a positive electrode voltage section corresponding to the battery based on a preset negative electrode flat section;
a profile adjustment step of adjusting a preset reference positive electrode profile and reference negative electrode profile to correspond to the battery profile based on the positive electrode voltage section; and
a profile generation step of generating a positive electrode profile and a negative electrode profile of the battery based on an adjustment result in the profile adjustment step.

12. A non-transitory computer-readable storage medium having stored therein a program for performing a battery information generating method, the method comprising:
a profile acquisition step of acquiring a battery profile representing a correspondence between a capacity and a voltage of a battery;
a positive electrode voltage section setting step of setting a positive electrode voltage section corresponding to the battery based on a preset negative electrode flat section;
a profile adjustment step of adjusting a preset reference positive electrode profile and reference negative electrode profile to correspond to the battery profile based on the positive electrode voltage section; and
a profile generation step of generating a positive electrode profile and a negative electrode profile of the battery based on an adjustment result in the profile adjustment step.
